# EUROPEAN PATENT SPECIFICATION

(11) **EP 4 443 524 B1**
(45) Date of publication and mention of the grant of the patent: **18.11.2026**
(21) Application number: 23214575.5
(22) Date of filing: 06.12.2023
(51) Int. Cl.: H10H 20/84, H10H 20/01, H10H 20/825, H10P 30/20

(54) **LIGHT EMITTING ELEMENT, DISPLAY DEVICE, AND METHOD OF MANUFACTURING LIGHT EMITTING ELEMENT**
LICHTEMITTIERENDES ELEMENT, ANZEIGEVORRICHTUNG UND VERFAHREN ZUR HERSTELLUNG DES LICHTEMITTIERENDEN ELEMENTS
ÉLÉMENT ÉLECTROLUMINESCENT, DISPOSITIF D'AFFICHAGE ET PROCÉDÉ DE FABRICATION D'ÉLÉMENT ÉLECTROLUMINESCENT

(30) Priority: 07.04.2023 KR 20230046138
(43) Date of publication of application: 09.10.2024
(73) Proprietor: Samsung Display Co., Ltd., Yongin-si, Gyeonggi-do 17113 (KR)
(72) Inventor: CHAE, Ji Song, 17113 Yongin-si (KR); KIM, Dae Hyun, 17113 Yongin-si (KR); PARK, Sang Ho, 17113 Yongin-si (KR); YOO, Jae Woong, 17113 Yongin-si (KR); YOO, Chul Jong, 17113 Yongin-si (KR); LEE, Sang Hoon, 17113 Yongin-si (KR); LEE, Joo Hee, 17113 Yongin-si (KR); JANG, Jin Hyuk, 17113 Yongin-si (KR); JEON, Sang Ho, 17113 Yongin-si (KR); CHOI, Seon Hong, 17113 Yongin-si (KR)
(74) Representative: Marks & Clerk LLP

(56) References cited:
- US-A1- 2012 238 046
- US-A1- 2018 374 991
- US-A1- 2022 165 786
- US-A1- 2022 223 755
- US-A1- 2023 087 256
- WANG M ET AL: "Diffusion mechanism and the thermal stability of fluorine ions in GaN after ion implantation", JOURNAL OF APPLIED PHYSICS, AMERICAN INSTITUTE OF PHYSICS, 2 HUNTINGTON QUADRANGLE, MELVILLE, NY 11747, vol. 105, no. 8, 21 April 2009 (2009-04-21), pages 83519 - 83519, XP012124909, ISSN: 0021-8979, DOI: 10.1063/1.3106561

## Description

### BACKGROUND

### 1. Technical Field

Various embodiments of the disclosure relate to a light emitting element, a display device, and a method of manufacturing the light emitting element.

### 2. Description of the Related Art

Recently, as interest in information display increases, research and development on display devices have been continuously conducted.
US 2022/223755 A1 relates to a diode array. US 2012/238046 A1 relates to LED mesa sidewall isolation by ion implantation.

### SUMMARY

Various embodiments of the disclosure may be directed to a light emitting element having a reduced structural defect rate, a method of manufacturing the light emitting element, and a display device.

Various embodiments of the disclosure may be directed to a light emitting element having improved emission efficiency and reliability, a method of manufacturing the light emitting element, and a display device.

An embodiment of the invention provides a light emitting element as recited in claim 1.

In an embodiment, the fluorinated area of the semiconductor stack structure may include GaFₓN₍₁₋ₓ₎, where 0 < x < 1.

In an embodiment, the fluorinated area may have a non-uniform fluorine (F) concentration gradient with respect to depth from an outer surface of the semiconductor stack structure.

In an embodiment, the fluorinated area may have a peak concentration of fluorine (F) at a depth in a range of about 0.001 µm to about 0.01 µm from the outer surface of the semiconductor stack structure.

In an embodiment, the peak concentration may be in a range of about 1.2x10¹⁸ [number/cm³] to about 1.6x10¹⁸ [number/cm³].

In an embodiment, the fluorinated area may cover an entirety of the side portion of the semiconductor stack structure.

In an embodiment, the fluorinated area may cover a side portion of the P-type semiconductor layer and a side portion of the active layer, and the fluorinated area may not cover a side portion of the N-type semiconductor layer.

In an embodiment, the insulating layer includes silicon oxide or metal oxide. The fluorinated area may be directly adjacent to the insulating layer.

In an embodiment, the metal oxide may include at least one metal selected from a group consisting of tantalum (Ta), hafnium (Hf), zirconium (Zr), lanthanum (La), titanium (Ti), and aluminium (Al).

In an embodiment, a binding energy between fluorine (F) and gallium (Ga) may be greater than a binding energy between oxygen (O) included in the silicon oxide or the metal oxide and gallium (Ga).

In an embodiment of the invention, the insulating layer includes a first insulating layer disposed on the side portion of the semiconductor stack structure, and a second insulating layer disposed on the first insulating layer. The first insulating layer is disposed between the fluorinated area and the second insulating layer. Each of the first insulating layer and the second insulating layer includes the silicon oxide or the metal oxide. The first insulating layer further includes fluorine (F). The second insulating layer does not include fluorine (F).

An embodiment of the invention provides a display device as recited in claim 8.

In an embodiment, the display device may further include a first electrode and a second electrode disposed on the base layer. The light emitting element may include a first end and a second end. The light emitting element may be electrically connected to the first electrode at the first end and may be electrically connected to the second electrode at the second end.

In an embodiment, the display device may further include a first alignment electrode and a second alignment electrode disposed on the base layer. The light emitting element may be aligned between the first alignment electrode and the second alignment electrode.

In an embodiment, the fluorinated area of the semiconductor stack structure may include GaFₓN₍₁₋ₓ₎, where 0 < x < 1.

In an embodiment, the fluorinated area may have a non-uniform fluorine (F) concentration gradient with respect to depth from an outer surface of the semiconductor stack structure. The fluorinated area may have a peak concentration of fluorine (F) at a depth in a range of about 0.001 µm to about 0.01 µm from the outer surface of the semiconductor stack structure. The peak concentration may be in a range of about 1.2x10¹⁸ [number/cm³] to about 1.6x10¹⁸ [number/cm³].

An embodiment of the invention provides a method of manufacturing a light emitting element as recited in claim 12.

In an embodiment, the forming of the fluorinated area may include providing fluorine (F) to the patterned semiconductor stack structure using an ion implantation technique and/or a surface treatment technique.

In an embodiment, the forming of the insulating layer includes forming a plurality of insulating layers after the forming of the fluorinated area.

In an embodiment of the invention, the forming of the insulating layer includes forming a first insulating layer on a side portion of the patterned semiconductor stack structure, and forming a second insulating layer on the first insulating layer. The forming of the first insulating layer is performed before the forming of the fluorinated area. The forming of the second insulating layer is performed after the forming of the fluorinated area.

At least some of the above and other features of the invention are set out in the claims.

### BRIEF DESCRIPTION OF THE DRAWINGS

The above and other aspects and features of the disclosure will become more apparent by describing in detail embodiments thereof with reference to the attached drawings, in which:
FIGS. 1, 2, and 4 are schematic sectional views illustrating a light emitting element in accordance with an embodiment;
FIG. 3 is a schematic perspective view illustrating a light emitting element in accordance with an embodiment;
FIGS. 5 and 6 are schematic enlarged sectional views each illustrating a portion of a light emitting element in accordance with an embodiment of the invention;
FIG. 7 is a graph illustrating a concentration profile of fluorine according to the position in a semiconductor stack structure;
FIG. 8 is a schematic flowchart illustrating a method of manufacturing a light emitting element in accordance with an embodiment;
FIGS. 9 to 14 are schematic sectional views illustrating, by process steps, a method of manufacturing the light emitting element in accordance with an embodiment;
FIG. 15 is a schematic flowchart illustrating a method of manufacturing a light emitting element in accordance with a partially modified embodiment;
FIGS. 16 to 17 are schematic sectional views illustrating, by process steps, a method of manufacturing the light emitting element in accordance with the partially modified embodiment;
FIG. 18 is a schematic plan view illustrating a display device including a light emitting element in accordance with an embodiment; and
FIGS. 19 to 21 are schematic sectional views each illustrating the display device in accordance with an embodiment.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in an embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be predisposed differently from the described order. For example, two consecutively described processes may be predisposed substantially at a same time or predisposed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Also, when an element is referred to as being "in contact" or "contacted" or the like to another element, the element may be in "electrical contact" or in "physical contact" with another element; or in "indirect contact" or in "direct contact" with another element. Further, the X-axis, the Y-axis, and the Z-axis may not be limited to three axes of a rectangular coordinate system, such as the x, y, and z axes, and may be interpreted in a broader sense. For example, the X-axis, the Y-axis, and the Z-axis may be perpendicular to one another, or may be different directions that may not be perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items. A description that a component is "configured to" perform a specified operation may be defined as a case where the component is constructed and arranged with structural features that can cause the component to perform the specified operation.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, may not be necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be disposed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, portion, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

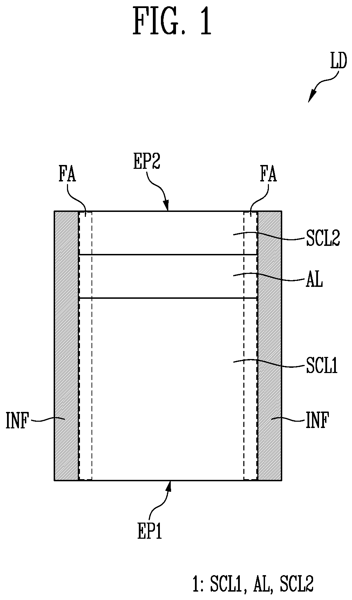

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein. A light emitting element LD in accordance with an embodiment will be described with reference to FIGS. 1 to 7.

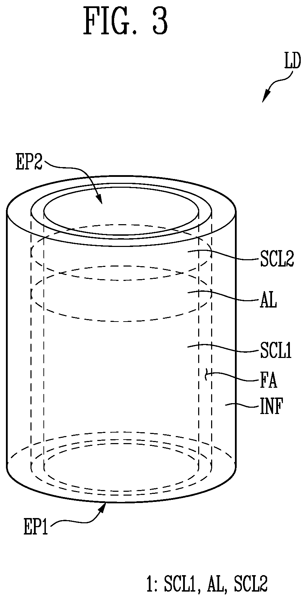

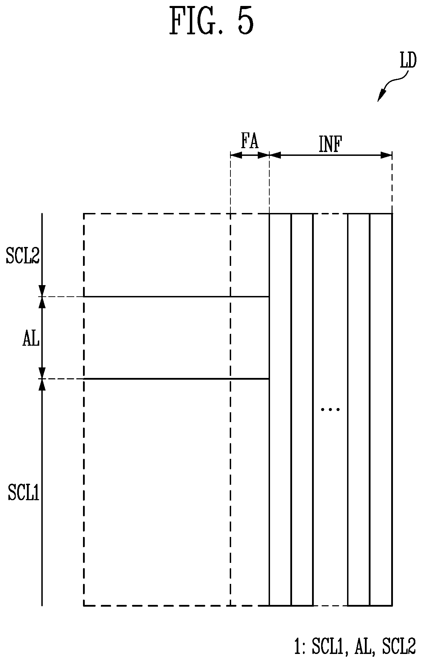

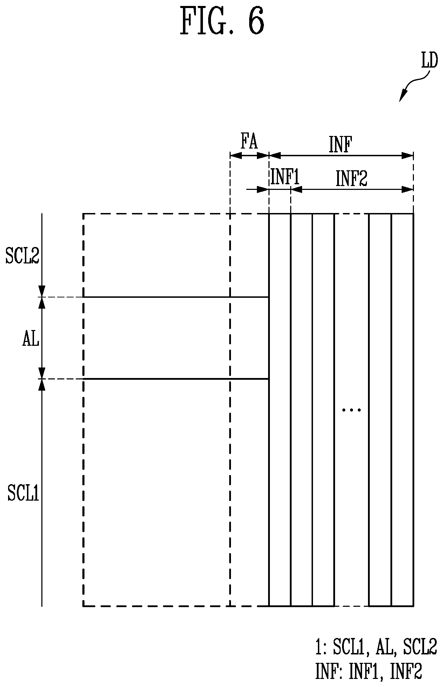

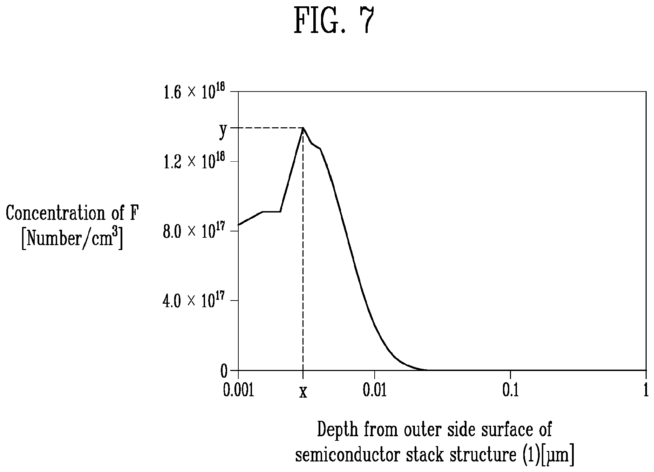

FIGS. 1, 2, and 4 are schematic sectional views illustrating a light emitting element in accordance with an embodiment. FIG. 3 is a schematic perspective view illustrating a light emitting element in accordance with an embodiment. FIGS. 5 and 6 are schematic enlarged sectional views each illustrating a portion of a light emitting element in accordance with an embodiment of the invention. FIG. 7 is a graph illustrating the concentration of fluorine according to the position in a semiconductor stack structure.

The light emitting element LD is configured to emit light. For example, the light emitting element LD may emit one of red light, green light, and blue light. Red light may be light including some wavelength bands in a wavelength band ranging from approximately 600 nm to approximately 750 nm. Green light may be light including some wavelength bands in a wavelength band ranging from approximately 480 nm to approximately 560 nm. Blue light may be light including some wavelength bands in a wavelength band ranging from approximately 370 nm to approximately 460 nm.

The light emitting element LD includes a semiconductor stack structure 1 including a fluorinated area FA, and an insulating layer INF. The semiconductor stack structure 1 also includes an N-type semiconductor layer SCL1, a P-type semiconductor layer SCL2, and an active layer AL disposed between the N-type semiconductor layer SCL1 and the P-type semiconductor layers SCL2.

The light emitting element LD may have various sizes. In an embodiment, the light emitting element LD may have a size ranging from the nanometer scale to the micrometer scale. For example, the diameter of the light emitting element LD may be about 100 µm or less. In an embodiment, the diameter of the light emitting element LD may be about 1 µm or less. Here, a criterion for measuring the diameter of the light emitting element LD may be determined depending on a cross-sectional shape of the light emitting element LD (e.g., the active layer AL). For example, in the case where the cross-section of the light emitting element LD may have a circular shape, the diameter thereof may correspond to the diameter of the circle. In the case where the cross-section of the light emitting element LD has an elliptical shape, the diameter thereof may correspond to the length of the long or major axis of the ellipse. In the case where the cross-section of the light emitting element LD has a polygonal shape, the diameter thereof may correspond to a length of a longest diagonal line of the polygon.

The light emitting element LD may include a first end EP1 and a second end EP2. In an embodiment, the N-type semiconductor layer SCL1 may be adjacent to the first end EP1 of the light emitting element LD. The P-type semiconductor layer SCL2 may be adjacent to the second end EP2 of the light emitting element LD. The first end EP1 and the second end EP2 may be defined based on the direction of an electrical path, which can be formed in the light emitting element LD.

The light emitting element LD may have various shapes. For example, the light emitting element LD may have a bar-like shape extending in one direction (refer to FIGS. 1 to 3). The light emitting element LD may have a shape extending in a direction from the first end EP1 toward the second end EP2.

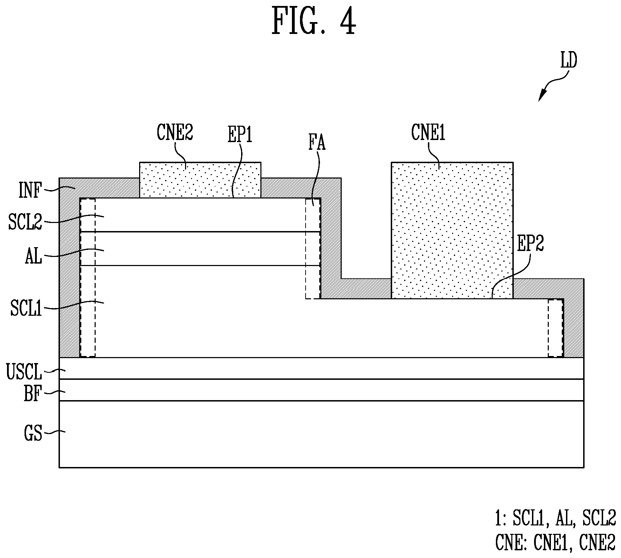

In an embodiment, the light emitting element LD may be manufactured as a flip-chip type light emitting diode (refer to FIG. 4). The P-type semiconductor layer SCL2 on the first end EP1 and the N-type semiconductor layer SCL1 on the second end EP2 may be oriented in a same direction in the flip-chip type light emitting diode of FIG. 4.

The N-type semiconductor layer SCL1 may be disposed below the active layer AL and include a semiconductor layer having a type different from that of the P-type semiconductor layer SCL2. For example, the N-type semiconductor layer SCL1 may include an N-type semiconductor. The N-type semiconductor layer SCL1 may include GaN-based material. For example, the N-type semiconductor layer SCL1 may include one or more selected from a group consisting of InAlGaN, GaN, AlGaN, and InGaN, and may include an N-type semiconductor doped with a first conductive dopant such as Si, Ge, and Sn. In an embodiment, the N-type semiconductor layer SCL1 may include GaN-based material including fluorine (F) in the fluorinated area FA.

The active layer AL is disposed between the N-type semiconductor layer SCL1 and the P-type semiconductor layer SCL2. The active layer AL may include a single-quantum well structure or a multi-quantum well structure. The position of the active layer AL may be changed in various ways depending on the type of the light emitting element LD, rather than being limited to a specific example.

The active layer AL may include a well layer and a barrier layer which may be provided to form a quantum well structure. For example, the active layer AL may include InGaN as a well layer, and the active layer AL may include GaN as a barrier layer. In an embodiment, the active layer AL may include GaN-based material including fluorine (F) in the fluorinated area FA.

The P-type semiconductor layer SCL2 may be disposed on the active layer AL and include a semiconductor layer having a type different from that of the N-type semiconductor layer SCL1. For example, the P-type semiconductor layer SCL2 may include a P-type semiconductor. The P-type semiconductor layer SCL2 may include GaN-based material. For example, the P-type semiconductor layer SCL2 may include one or more selected from the group consisting of InAlGaN, GaN, AlGaN, and InGaN, and may include a P-type semiconductor doped with a second conductive dopant such as Ga, B, and Mg. In an embodiment, the P-type semiconductor layer SCL2 may include GaN-based material including fluorine (F) in the fluorinated area FA.

In the case that a voltage of a threshold voltage or more is applied between the first end EP1 and the second end EP2 of the light emitting element LD, an electron-hole pair in the active layer AL may be recombined so that excitons can be formed, whereby the light emitting element LD may emit light. Since light emission of the light emitting element LD can be controlled based on the foregoing principle, the light emitting element LD may be used as a light source in various devices.

Experimentally, an etching process (e.g., a dry etching process) for manufacturing the light emitting element LD may affect the emission efficiency of the light emitting element LD. For example, a side portion of the light emitting element LD may be damaged, so that there may be a risk of damage to the active layer AL. The emission efficiency of the light emitting element LD may be damaged (e.g., the emission efficiency may reduce due to an increase of non-radiative recombination).

In the specification, the term "side portion" may mean an area of an object (e.g., the semiconductor stack structure 1, the active layer AL, the N-type semiconductor layer SCL1, the P-type semiconductor layer SCL2, or the like) including a portion of a remaining area except an upper surface and a lower surface of the object. Here, the upper surface and the lower surface of the object may mean surfaces corresponding to the first end EP1 or the second end EP2 of the light emitting element LD (or the semiconductor stack structure 1) respectively. In an embodiment, the side portion may mean a portion of the outer surface of the object that is defined in an area between the first end EP1 and the second end EP2 of the light emitting element LD (or the semiconductor stack structure 1).

In an embodiment, the light emitting element LD may be characteristic in that the fluorinated area FA may be formed in a side portion of the semiconductor stack structure 1. The fluorinated area FA may be an area including a crystal structure including fluorine (F).

The fluorinated area FA may be formed in the side portion of the semiconductor stack structure 1 that is adjacent to the insulating layer INF. The fluorinated area FA may be formed adjacent to the side portion of the semiconductor stack structure 1 that is adjacent (e.g., directly adjacent) to the insulating layer INF. The fluorinated area FA may be disposed between at least an internal portion of the semiconductor stack structure 1 and the insulating layer INF. For example, the fluorinated area FA may be adjacent (e.g., directly adjacent) to a silicon oxide or a metal oxide included in the insulating layer INF.

The fluorinated area FA may be adjacent to an etched surface processed through an etching process performed in the case that the semiconductor stack structure 1 is patterned. For example, in the case where the N-type semiconductor layer SCL1, the active layer AL, and the P-type semiconductor layer SCL2 may be etched simultaneously, an etched surface may be defined on the side portion of the semiconductor stack structure 1, and the fluorinated area FA may be adjacent to or correspond to at least a portion of the defined etched surface.

The fluorinated area FA may be an area formed by doping the side portion of the semiconductor stack structure 1 with fluorine (F). Fluorine (F) supplied to form the fluorinated area FA may form at least a portion of the crystal structure in the side portion of the semiconductor stack structure 1.

For example, the fluorinated area FA may be formed in an overall surface of the side portion of the semiconductor stack structure 1 (refer to FIGS. 1, 3, and the like). Hence, the fluorinated area FA may be formed in a side portion of the N-type semiconductor layer SCL1, may be formed in a side portion of the active layer AL, and may also be formed in a side portion of the P-type semiconductor layer SCL2.

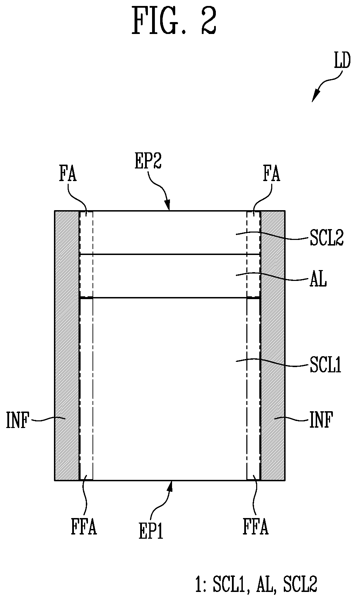

In another example, the fluorinated area FA may be formed in the side portion of the active layer AL without being formed in the side portion of the N-type semiconductor layer SCL1, and may also be formed in the side portion of the P-type semiconductor layer SCL2 (refer to FIG. 2). A fluorinated-free area FFA that does not include fluorine (F) may be formed in the side portion of the N-type semiconductor layer SCL1.

Fluorine (F) may be distributed in the fluorinated area FA according to a concentration profile with respect to a depth from an outer side surface of the semiconductor stack structure 1. The foregoing will be described in detail with reference to FIG. 7. Here, the outer side surface of the semiconductor stack structure 1 may correspond to the side portion of the semiconductor stack structure 1, and may refer to a peripheral surface of the semiconductor stack structure 1 that may be adjacent (e.g., directly adjacent) to the insulating layer INF. The term "depth" to be described below may refer to a distance between a target position and the outer side surface of the semiconductor stack structure 1.

The concentration of fluorine (F) may have a profile which increases with depth from the outer side surface of the semiconductor stack structure 1 and decreases from the peak concentration. For example, the concentration of fluorine (F) may have a peak concentration y at a peak position x included in a numerical range from about 0.001 µm to about 0.01 µm. In an embodiment, the peak concentration y may be included in a range from about 1.2x10¹⁸ [number/cm³] to about 1.6x10¹⁸ [number/cm³].

In other words, fluorine (F) may be distributed with a non-uniform concentration gradient in the fluorinated area FA, and may be provided with the peak concentration at least at some positions. Because the foregoing concentration gradient of fluorine (F) may be provided, the fluorinated area FA may function as a barrier layer of the semiconductor stack structure 1 against external influences.

The fluorinated area FA may include GaFN-based material. For example, GaFₓN₍₁₋ₓ₎ may be included in the fluorinated area FA, where 0 < x < 1. However, the disclosure may not be limited to the foregoing. For example, the GaFN-based material may further include one or more elements. In an embodiment, the GaFN-based material may include InₓAl_{y}Ga_{(1-x- y)}FₘNₙ, where 0 < x < 1, 0 < y < 1, 0 < x+y < 1, 0 < m < 1, and 0 < n < 1.

In an embodiment, in a GaN crystal structure forming the semiconductor stack structure 1, fluorine (F) may be disposed in vacancy in which nitrogen (N) may be absent, and may form a bonding structure with gallium (Ga). Fluorine (F) may have relatively high electronegativity and form a bonding structure having high binding energy with gallium (Ga). Hence, GaFN may form a crystal structure having high stability.

In the fluorinated area FA, the risk of other elements besides fluorine (F) infiltrating the GaN crystal structure (e.g., a wurtzite crystal structure) may be reduced. For example, experimentally, in the case where hydrogen (H) and oxygen (O) may be provided to the GaN crystal structure, the hydrogen (H) and the oxygen (O) may function as donor elements, so that there may be a concern about a reduction in structural stability of the GaN crystal structure. Particularly, because the insulating layer INF may include silicon oxide or metal oxide, there may be a concern about presence of some oxygen (O) that can form a metal oxide in the GaN crystal structure. In the case that oxygen (O) is introduced to the GaN crystal structure, crystal structures such as GaON and Ga₂O₃ may form, thus reducing the stability of the GaN crystal structure.

However, because fluorine (F) capable of forming a bonding structure with binding energy with gallium (Ga) may be provided to the GaN crystal structure, there may be a reduced risk of deformation of the GaN crystal structure in the side portion (e.g., an etching interface) of the semiconductor stack structure 1. For example, Ga-F bonding may have high binding energy compared to Ga-O bonding. H-F bonding may have high binding energy compared to H-O bonding. The Ga-F bonding may have binding energy of approximately 6.0 eV. The Ga-O bonding may have binding energy of approximately 3.9 eV. The H-F bonding may have binding energy of approximately 5.9 eV The H-O bonding may have binding energy of approximately 4.8 eV. Therefore, the Ga-F bonding and/or the H-F bonding may be robustly formed, so that the risk of hydrogen (H) or oxygen (O) infiltration into the GaN crystal structure may be reduced.

Accordingly, the fluorinated area FA may reduce the occurrence of defects in the side portion of the semiconductor stack structure 1, may mitigate the risk of structural variations (such as self-trapping of excitons causing lattice vibrations in the crystal structure) due to external influences, and may reduce the risk of material property changes in GaN. Hence, the emission efficiency of the light emitting element LD may be improved, and the reliability of the emission of the light emitting element LD may be enhanced. For example, if the structural stability of the GaN crystal structure deteriorates, strain may occur in the GaN crystal structure, thus making it difficult for the light emitting element LD to emit light at a desired luminance. However, the fluorinated area FA may reduce such risks.

The insulating layer INF may enclose the side portion of the semiconductor stack structure 1. The insulating layer INF is disposed on the semiconductor stack structure 1 including the N-type semiconductor layer SCL1, the active layer AL, and the P-type semiconductor layer SCL2.

The insulating layer INF may be disposed on the fluorinated area FA. The insulating layer INF may protect the semiconductor stack structure 1 from external influences, and may insulate the N-type semiconductor layer SCL1, the active layer AL, and the P-type semiconductor layer SCL2 from the outside.

The insulating layer INF may include insulating silicon oxide or material including metal oxide. For example, the insulating layer INF may include silicon oxide or metal oxide including at least one metal selected from a group consisting of tantalum (Ta), hafnium (Hf), zirconium (Zr), lanthanum (La), titanium (Ti), and aluminium (Al). However, the disclosure may not be limited to a specific example.

The insulating layer INF includes two or more insulating layers each including silicon oxide or metal oxide (refer to FIG. 5). For example, the insulating layer INF may have a structure in which two or more insulating layers including different materials may be successively stacked on each other. For example, the insulating layer INF may include a first insulating layer including M1_{X}O_{Y} and a second insulating layer including M2_{U}O_{Z} (M1 and M2 may be silicon or metal). The number of insulating layers for forming the insulating layer INF may not be particularly limited.

In an embodiment of the invention, the insulating layer INF includes a first insulating layer INF1 and a second insulating layer INF2 (refer to FIG. 6). Here, the second insulating layer INF2 may have an insulating structure including two or more insulating layers each including silicon oxide or metal oxide, as described above. The first insulating layer INF1 may be a layer formed separately from the second insulating layer INF2.

In an embodiment, the first insulating layer INF1 may be referred to as a preliminary insulating layer.

According to the invention, the first insulating layer INF1 is disposed between the fluorinated area FA of the semiconductor stack structure 1 and the second insulating layer INF2. A surface of the first insulating layer INF1 may contact the side portion of the semiconductor stack structure 1, and another surface of the first insulating layer INF1 may contact the second insulating layer INF2. In an embodiment, the first insulating layer INF1 may cover respective side portions of the N-type semiconductor layer SCL1, the active layer AL, and the P-type semiconductor layer SCL2. However, the disclosure may not be limited to the foregoing. In an embodiment, the first insulating layer INF1 may instead be disposed on the N-type semiconductor layer SCL1 without being disposed on the active layer AL and the P-type semiconductor layer SCL2.

The first insulating layer INF1 includes one or more of the above-mentioned silicon oxide and metal oxides, and further includes fluorine (F). For example, the first insulating layer INF1 may include silicon oxide or metal oxide manufactured to have an amorphous structure, and fluorine (F) may be included in at least some portions in the structure formed by the silicon oxide or the metal oxide. According to the invention, the second insulating layer INF2 includes one or more of the above-mentioned silicon oxide and metal oxides, and does not include fluorine (F).

The first insulating layer INF1 may cap at least a portion of the semiconductor stack structure 1 during a process of forming the fluorinated area FA. For example, the first insulating layer INF1 may protect the semiconductor stack structure 1 from influences of the process of forming the fluorinated area FA.

For instance, fluorine (F) that may be doped into the semiconductor stack structure 1 to form the fluorinated area FA may have kinetic energy. For example, in the case where fluorine (F) penetrates into the semiconductor stack structure 1 using plasma or the like, there may be a concern about generation of strain in the semiconductor stack structure 1 due to the kinetic energy possessed by the fluorine (F). However, in an embodiment, by preliminarily forming the first insulating layer INF1 before the fluorinated area FA is formed, the first insulating layer INF1 may reduce the kinetic energy possessed by the fluorine (F), whereby the aforementioned risks may be reduced.

In an embodiment, the structure of the light emitting element LD may not be limited thereto, and may further include an additional layer(s). For example, the light emitting element LD may further include an electron blocking layer configured to prevent electrons from overflowing. The light emitting element LD may further include a superlattice layer configured to relieve stress in the light emitting element LD. Furthermore, the light emitting element LD may further include an electrode layer which may be disposed on the P-type semiconductor layer SCL2 and electrically connected to the P-type semiconductor layer SCL2.

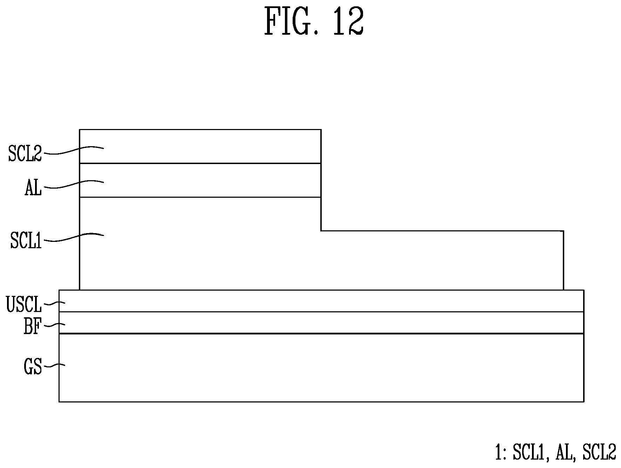

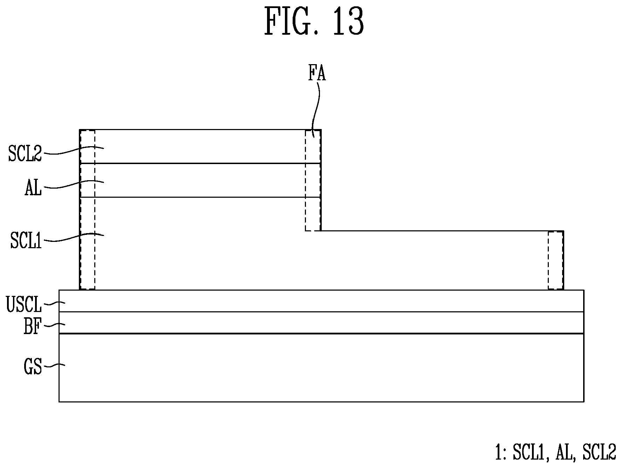

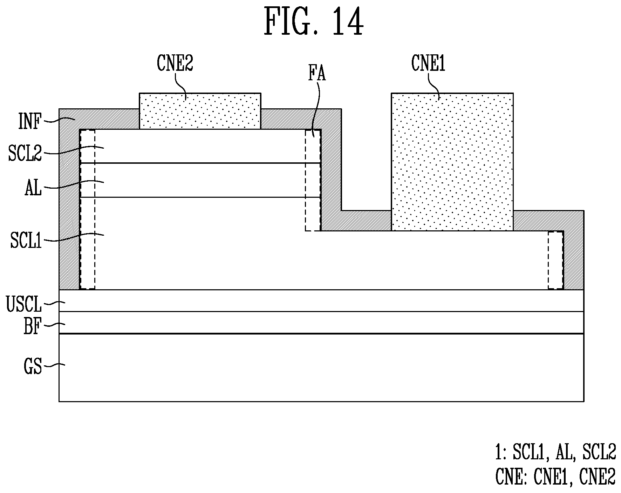

In the case where the light emitting element LD may be a flip-chip type light emitting diode, the light emitting element LD may include a first connection electrode CNE1 electrically connected to the N-type semiconductor layer SCL1, a second connection electrode CNE2 electrically connected to the P-type semiconductor layer SCL2, a growth substrate GS configured to form a base of the N-type semiconductor layer SCL1, and a buffer layer BF and an undoped semiconductor layer USCL which may be disposed between the growth substrate GS and the N-type semiconductor layer SCL1. Detailed description of the growth substrate GS, the buffer layer BF, and the undoped semiconductor layer USCL will be provided later with reference to FIGS. 12 to 14.

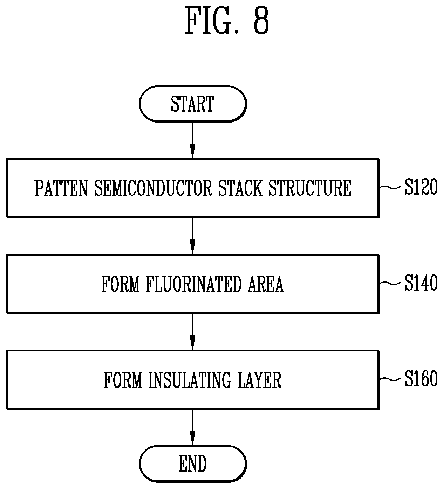

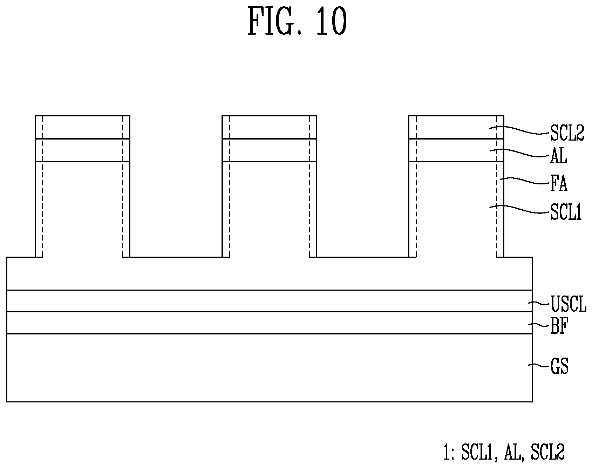

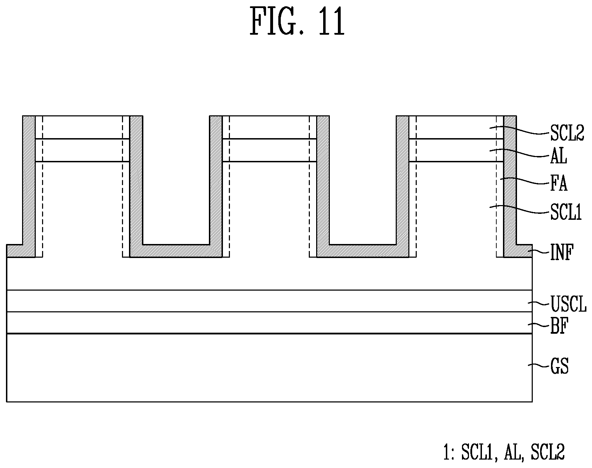

Hereinafter, a method of manufacturing the light emitting element LD in accordance with an embodiment will be described with reference to FIGS. 8 to 17. Description overlapping that of the contents described above will be simplified, or may not be repeated.

First, an embodiment in which the insulating layer INF may not be formed before the fluorinated area FA is formed will be described with reference to FIGS. 8 to 14.

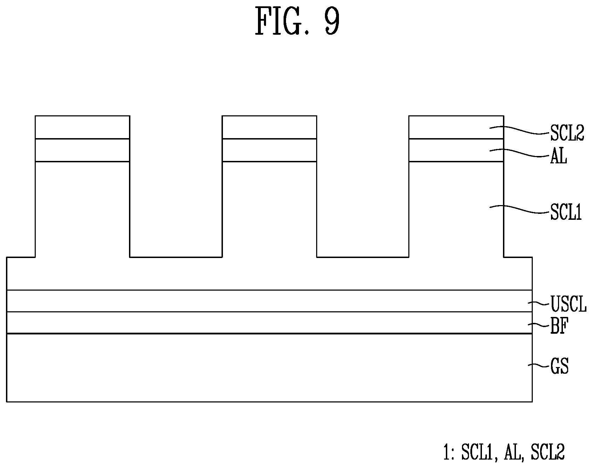

FIG. 8 is a schematic flowchart illustrating a method of manufacturing the light emitting element in accordance with an embodiment. FIGS. 9 to 14 are schematic sectional views illustrating, by process steps, a method of manufacturing the light emitting element in accordance with an embodiment. FIGS. 9 to 11 are schematic diagrams illustrating a method of manufacturing a light emitting element LD (e.g., refer to FIGS. 1 to 3) having a shape extending in one direction. FIGS. 12 to 14 are schematic diagrams illustrating a method of manufacturing a flip-chip type light emitting element LD (e.g., refer to FIG. 4).

Referring to FIG. 8, the method of manufacturing the light emitting element LD in accordance with an embodiment includes step S120 of patterning a semiconductor stack structure, step S140 of forming a fluorinated area, and step S160 of forming an insulating layer.

Referring to FIGS. 8, 9, and 12, at step S120 of patterning the semiconductor stack structure, the semiconductor stack structure 1 may be patterned by growing a buffer layer BF, an undoped semiconductor layer USCL, an N-type base semiconductor layer, a base active layer, and a P-type base semiconductor layer on a growth substrate GS, and etching at least a portion of each of the N-type base semiconductor layer, the base active layer, and the P-type base semiconductor layer. In an embodiment, the etching process may be performed such that a side portion of the semiconductor stack structure 1 may be exposed. In an embodiment, to manufacture a flip-chip type light emitting element LD, an etching process may be performed so that a surface of the N-type semiconductor layer SCL1 may be exposed (refer to FIG. 12).

The growth substrate GS may be a base board provided to grow a target material. For example, the growth substrate GS may be a wafer for epitaxial growth of the target material. The growth substrate GS may be a substrate including Si, GaAs, and the like, and material for forming the growth substrate GS may not be limited to a particular example.

The buffer layer BF may enhance the crystallinity of the semiconductor layers formed on the growth substrate GS. In an embodiment, the buffer layer BF may include one or more selected from a group consisting of InAlGaN, GaN, AlGaN, InGaN, AlN, and InN. However, the disclosure may not be limited to the foregoing.

The undoped semiconductor layer USCL may reduce defects in the semiconductor layers formed on the growth substrate GS. In an embodiment, the undoped semiconductor layer USCL may include a same material as a semiconductor material for forming the semiconductor stack structure 1 as a semiconductor material which does not include a separate dopant, but the material for forming the undoped semiconductor layer USCL may not be limited to a particular example.

The N-type base semiconductor layer, the base active layer, and the P-type base semiconductor layer may be formed by sequential epitaxial growth. The N-type base semiconductor layer may include a material for forming the N-type semiconductor layer SCL1. The base active layer may include material for forming the active layer AL. The P-type base semiconductor layer may include a material for forming the P-type semiconductor layer SCL2.

Referring to FIGS. 8, 10, and 13, at step S140 of forming a fluorinated area, the fluorinated area FA may be formed. At the present step, the side portion of the semiconductor stack structure 1 may be doped with fluorine (F). In an embodiment, a crystal structure including GaFN may be formed in the side portion of the semiconductor stack structure 1.

For example, the fluorinated area FA may be produced by an ion implantation technique of implanting fluorine (F) ions into a side portion of semiconductor stack structure 1. In the case of the ion implantation technique, energy to be applied to the ions to be doped may be adjusted, thus making it possible to control a depth at which the ions penetrate through an outer surface of the semiconductor stack structure 1. In an embodiment, energy of approximately 5 keV may be supplied to ions. The peak concentration of fluorine (F) in the fluorinated area FA may be about 1.0x10¹⁵ [number/cm³] or more. In an embodiment, the peak concentration of fluorine (F) may be about 1.2x10¹⁵ [number/cm³] or more. In an embodiment, the peak concentration of fluorine (F) may be included in a range from about 1.2x10¹⁸ [number/cm³] to about 1.6x10¹⁸ [number/cm³]. However, the disclosure may not be limited to the foregoing.

In another example, the fluorinated area FA may be an area formed by supplying fluorine (F) thereto through a surface treatment process. The surface treatment process may be an annealing process or a surface treatment process using plasma. However, the disclosure may not be limited thereto.

In an embodiment, an area where the fluorinated area FA may be formed may be selectively defined in some areas of the side portions of the semiconductor stack structure 1. For example, the fluorinated area FA may be formed in the overall surface of the side portion of the semiconductor stack structure 1. In an embodiment, the fluorinated area FAmay instead be selectively formed in a side portion of the active layer AL and in a side portion of the P-type semiconductor layer SCL2.

Referring to FIGS. 8, 11, and 14, at step S160 of forming the insulating layer, the insulating layer INF may be patterned, so that the insulating layer INF can cover the semiconductor stack structure 1.

For example, the insulating layer INF may be formed (or deposited) by various techniques. For instance, an atomic layer deposition (ALD) technique, a chemical vapor deposition (CVD) technique, or the like may be used. However, the disclosure may not be limited to the foregoing. The formed insulating layer INF may be etched so that the semiconductor stack structure 1 may be electrically exposed.

In an embodiment, the insulating layer INF may be formed by alternately forming different materials so as to include two or more insulating layers. As described above, the insulating layer INF may include a silicon oxide or metal oxide.

In an embodiment, although not illustrated, there may be an additional step of patterning an electrode layer electrically connected to at least a portion of the semiconductor stack structure 1.

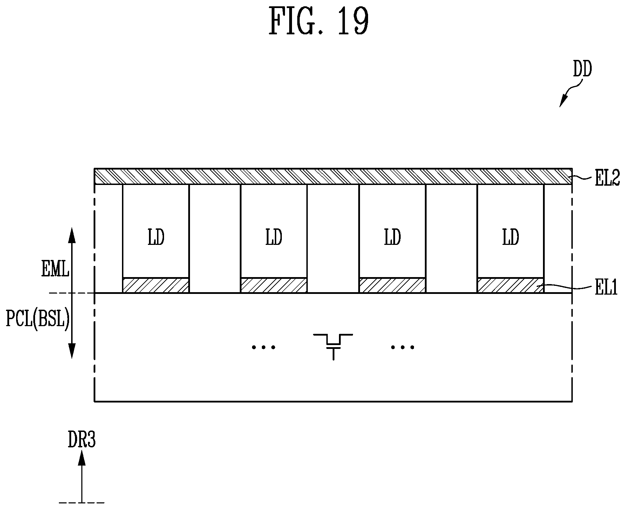

In an embodiment (e.g., refer to FIGS. 9 to 11), the step of providing individual light emitting elements LD by dividing the structure including the semiconductor stack structure 1 and the insulating layer INF into parts may be further performed. For example, a portion of the N-type semiconductor layer SCL1 may be cut. In an embodiment, a laser lift off (LLO) technique may be performed to cut a portion of the N-type semiconductor layer SCL1. However, the disclosure may not be limited to the foregoing. Depending on the embodiment, the step of dividing the structure including the semiconductor stack structure 1 and the insulating layer INF may not be performed, and the light emitting element LD may instead be manufactured by transferring a structure including the semiconductor stack structure 1 onto a backplane layer (e.g., a pixel circuit layer PCL (refer to FIG. 19) including driving circuit), and removing the growth substrate GS or the like.

Depending on the embodiment (e.g. refer to FIGS. 12 to 14), there may be an additional step of forming a connection electrode CNE. The connection electrode CNE may be patterned before the insulating layer INF is formed. In an embodiment, the connection electrode CNE may be patterned after the insulating layer INF is formed. The connection electrode CNE may include a first connection electrode CNE1, and a second connection electrode CNE2. The first connection electrode CNE1 may be electrically connected to the N-type semiconductor layer SCL1, and may be configured to electrically connect a cathode electrode for the light emitting element LD to the semiconductor stack structure 1. The second connection electrode CNE2 may be electrically connected to the P-type semiconductor layer SCL2, and may be configured to electrically connect an anode electrode for the light emitting element LD to the semiconductor stack structure 1. In an embodiment, to manufacture a flip-chip type light emitting element LD, a desired structure of the light emitting element LD may be formed without performing a separate process of removing layers that form the base of the semiconductor stack structure 1.

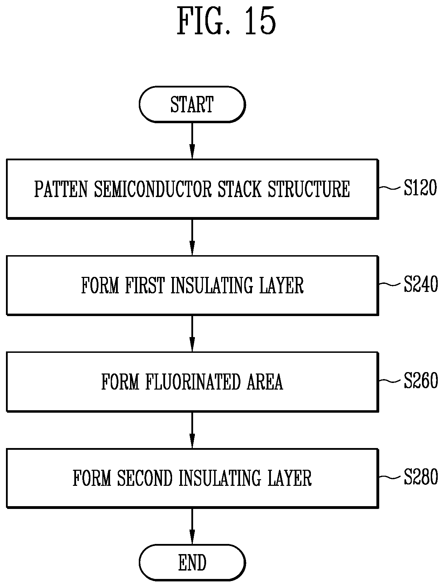

An embodiment in which a portion of the insulating layer INF may be formed before the fluorinated area FA is formed will be described with reference to FIGS. 15 to 17. A method of manufacturing a light emitting element LD will be described focusing on differences compared to the content described above with reference to FIGS. 8 to 14.

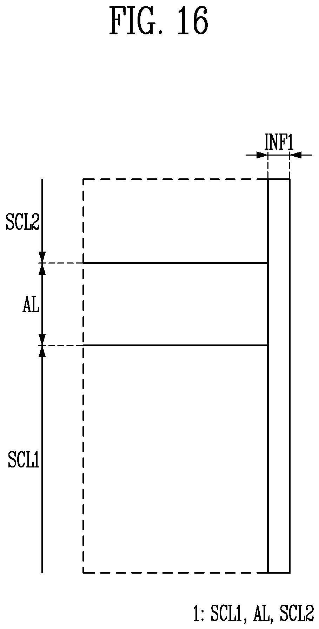

FIG. 15 is a schematic flowchart illustrating a method of manufacturing a light emitting element in accordance with a partially modified embodiment. FIGS. 16 to 17 are schematic sectional views illustrating, by process steps, a method of manufacturing the light emitting element in accordance with the partially modified embodiment.

The present manufacturing method according to the invention differs to the manufacturing method described above in that the step of forming the first insulating layer INF1 is performed before the fluorinated area FA is formed.

For example, the method of manufacturing the light emitting element LD in accordance with the embodiment may include step S120 of patterning a semiconductor stack structure, step S240 of forming a first insulating layer, step S260 of forming a fluorinated area, and step S280 of forming a second insulating layer.

In an embodiment, before the fluorinated area FA is formed, step S240 of forming the first insulating layer INF1 may be performed.

For example, referring to FIG. 16, after the semiconductor stack structure 1 is patterned, the first insulating layer INF1 may be patterned on the side portion of the semiconductor stack structure 1. In an embodiment, the first insulating layer INF1 may be patterned on the entirety of the side portion of the semiconductor stack structure 1. In an embodiment, the first insulating layer INF1 may be selectively partially patterned on the side portion of the semiconductor stack structure 1. For example, the first insulating layer INF1 may be patterned on the N-type semiconductor layer SCL1 without being patterned on the active layer AL and the P-type semiconductor layer SCL2. Accordingly, the first insulating layer INF1 may not be disposed in the active layer AL and the P-type semiconductor layer SCL2 where fluorine (F) may be required at a relatively high concentration in the fluorinated area FA. The first insulating layer INF1 may be selectively disposed in the N-type semiconductor layer SCL1 where fluorine (F) may not be required at a relatively high concentration.

In an embodiment, the first insulating layer INF1 may include one or more of the silicon oxide and metal oxides described above with regard to the insulating layer INF.

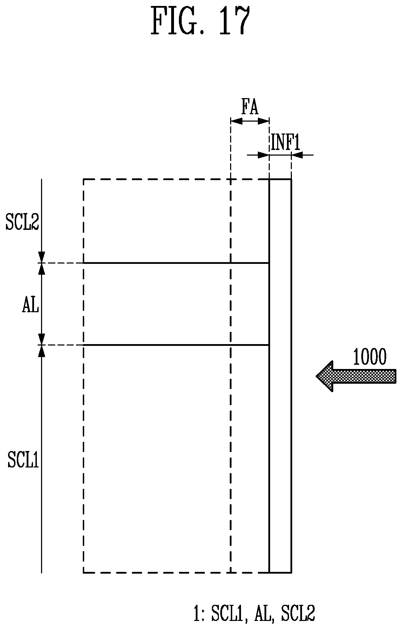

Referring to FIG. 17, after the first insulating layer INF1 may be formed, step S260 of forming the fluorinated area may be performed.

At step S260, the first insulating layer INF1 may reduce physical influence on the semiconductor stack structure 1 that may occur during the process of forming the fluorinated area FA. For example, as described above, process environment 1000 for forming the fluorinated area FA may influence the bonding structure of the semiconductor stack structure 1, so that there may be a concern about a reduction in the reliability of the light emission of the semiconductor stack structure 1. However, in the embodiment, the first insulating layer INF1 capable of passivating the side portion of the semiconductor stack structure 1 may be provided before the fluorinated area FA is formed, thus leading in protecting the semiconductor stack structure 1 from the process environment 1000 for forming the fluorinated area FA. Furthermore, after fluorine (F) ions having high kinetic energy pass through the first insulating layer INF1 and thus are reduced in kinetic energy thereof, the fluorine (F) ions can finally be doped into the semiconductor stack structure 1. Hence, the risk of energy generated during the process damaging the structure of the semiconductor stack structure 1 may be reduced.

Thereafter, according to the invention, step S280 of forming the second insulating layer is performed so that the second insulating layer INF2 is patterned on the first insulating layer INF1.

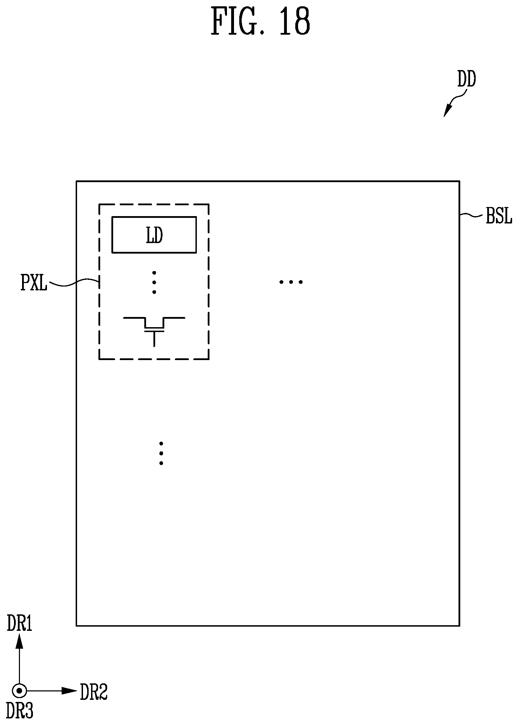

Hereinafter, a display device DD including the light emitting element LD in accordance with an embodiment will be described with reference to FIGS. 18 to 21. Description overlapping that of the contents described above will be simplified, or may not be repeated.

FIG. 18 is a schematic plan view illustrating a display device DD including a light emitting element in accordance with an embodiment. FIGS. 19 to 21 are schematic sectional views each illustrating the display device DD in accordance with an embodiment. Referring to FIGS. 18 to 21, the display device DD in accordance with an embodiment may include a base layer BSL, and pixels PXL formed on the base layer BSL.

In an embodiment, the base layer BSL may be a component for forming a base surface on which the pixel PXL may be disposed, and may be a substrate or a film. In an embodiment, the base layer BSL may be a rigid substrate made of glass. The base layer BSL may instead be a flexible substrate which can be bent, folded, or rolled. The substrate may include insulating material such as polymer resin, e.g., polyimide.

In an embodiment, the pixels PXL may include the aforementioned light emitting elements LD.

In an embodiment, the display device DD may include the base layer BSL, and a pixel circuit layer PCL including a driving circuit on the base layer BSL. Furthermore, the display device DD may include a light-emitting-element layer EML, which may be disposed on the pixel circuit layer PCL, and in which the light emitting elements LD may be disposed.

In an embodiment, the light emitting elements LD may be transferred onto the pixel circuit layer PCL, and may emit light based on electrical signals provided from a first electrode EL1 and a second electrode EL2.

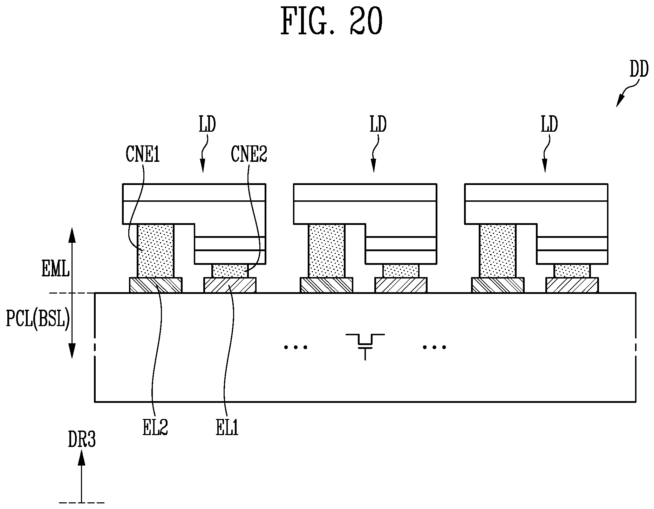

For example, in an embodiment (refer to FIG. 19), the light emitting elements LD may be individually separated from each other and transferred onto the first electrode EL1. In an embodiment (refer to FIG. 20), in the case that the light emitting elements LD are formed of flip-chip type light emitting diodes, each of the light emitting elements LD may be transferred such that the first connection electrode CNE1 may be electrically connected to the second electrode EL2, and the second connection electrode CNE2 may be electrically connected to the first electrode EL1.

In an embodiment, the light-emitting-element layer EML may include the first electrode EL1 electrically connected to an end of the light emitting element LD, and the second electrode EL2 electrically connected to another end of the light emitting element LD.

The light emitting elements LD may provide light based on electrical signals supplied from driving transistors of driving circuits (e.g., electrical signals provided from the first electrode EL1 and the second electrode EL2). In an embodiment, the light emitting elements LD may respectively emit various colors of light. Light emitting elements LD that emit a same color of light may respectively form sub-pixels. The formed sub-pixels may form one or more pixels PXL (or pixel portions).

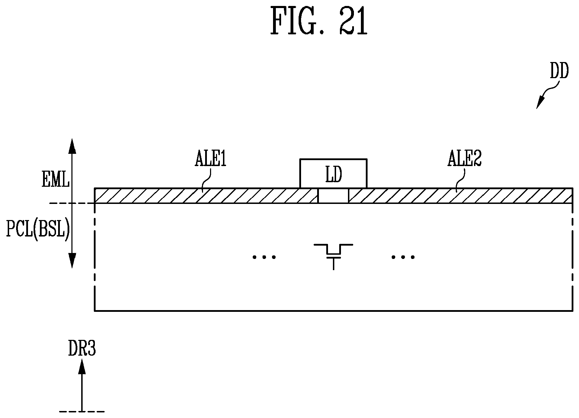

In an embodiment (refer to FIG. 21), the light emitting elements LD may be aligned (or disposed) between a first alignment electrode ALE1 and a second alignment electrode ALE2 on the pixel circuit layer PCL. For example, to dispose the light emitting elements LD on the pixel circuit layer PCL, a first alignment signal (e.g., an AC signal) may be supplied to the first alignment electrode ALE1, and a second alignment signal (e.g., a ground signal) may be supplied to the second alignment electrode ALE2. An electric field may be formed between the first alignment electrode ALE1 and the second alignment electrode ALE2, so that the light emitting elements LD may be aligned based on the formed electric field. In an embodiment, the first end EP1 of the light emitting element LD aligned between the first alignment electrode ALE1 and the second alignment electrode ALE2 may be electrically connected to a cathode (or anode) electrode (not illustrated), and the second end EP2 of the light emitting element LD may be electrically connected to an anode (or cathode) electrode (not illustrated), so that the light emitting element LD can be configured to emit light.

As described above, the light emitting elements LD may be manufactured to have reduced process-related risks and increased emission efficiency, so that the display device DD including the light emitting elements LD in accordance with an embodiment may be manufactured as a high-quality product.

Various embodiments of the disclosure may provide a light emitting element having a reduced structural defect rate, a method of manufacturing the light emitting element, and a display device.

Various embodiments of the disclosure may provide a light emitting element having improved emission efficiency and reliability, a method of manufacturing the light emitting element, and a display device including the light emitting element.

While various embodiments have been described above, those skilled in the art will appreciate that various modifications, additions and substitutions may be possible, without departing from the scope of the disclosure. Therefore, the embodiments disclosed in this specification may be only for illustrative purposes rather than limiting the invention. The scope of the invention is defined by the accompanying claims.

## Claims

1. A light emitting element (LD) comprising:
a semiconductor stack structure (1) including:
an N-type semiconductor layer (SCL1);
a P-type semiconductor layer (SCL2); and
an active layer (AL) disposed between the N-type semiconductor layer (SCL1) and the P-type semiconductor layer (SCL2); and
an insulating layer (INF) disposed on a side portion of the semiconductor stack structure (1),
**characterised in that**
the semiconductor stack structure (1) further includes a fluorinated area (FA) disposed adjacent to the insulating layer (INF),
the insulating layer (INF) includes a first insulating layer (INF1) disposed on the side portion of the semiconductor stack structure (1), and a second insulating layer (INF2) disposed on the first insulating layer (INF1),
the first insulating layer (INF1) is disposed between the fluorinated area (FA) and the second insulating layer (INF2),
each of the first insulating layer (INF1) and the second insulating layer (INF2) includes a silicon oxide or a metal oxide,
the first insulating layer (INF1) further includes fluorine (F), and
the second insulating layer (INF2) does not include fluorine (F).

2. The light emitting element (LD) according to claim 1, wherein
the fluorinated area (FA) of the semiconductor stack structure (1) comprises a GaFN-based material, and
the fluorinated area (FA) has a non-uniform fluorine (F) concentration gradient with respect to depth from an outer surface of the semiconductor stack structure (1).

3. The light emitting element (LD) according to claim 2, wherein
the fluorinated area (FA) has a peak concentration of fluorine (F) at a depth in a range of 0.001 µm to 0.01 µm from the outer surface of the semiconductor stack structure (1), and
the peak concentration is in a range of 1.2x10¹⁸ [number/cm³] to 1.6x10¹⁸ [number/cm³].

4. The light emitting element (LD) according to any one of claims 1 to 3, wherein the fluorinated area (FA) covers an entirety of the side portion of the semiconductor stack structure (1).

5. The light emitting element (LD) according to any one of claims 1 to 3, wherein
the fluorinated area (FA) covers a side portion of the P-type semiconductor layer (SCL2) and a side portion of the active layer (AL), and
the fluorinated area (FA) does not cover a side portion of the N-type semiconductor layer (SCL1).

6. The light emitting element (LD) according to any one of claims 2 to 5, wherein
the fluorinated area (FA) is directly adjacent to the insulating layer (INF), and
the metal oxide comprises at least one metal selected from a group consisting of tantalum (Ta), hafnium (Hf), zirconium (Zr), lanthanum (La), titanium (Ti), and aluminium (Al).

7. The light emitting element (LD) according to claim 6, wherein a binding energy between fluorine (F) and gallium (Ga) is greater than a binding energy between oxygen included in the silicon oxide or the metal oxide and gallium (Ga).

8. A display device, comprising:
a base layer (BSL); and
a light emitting element (LD) disposed on the base layer (BSL), wherein
the light emitting element (LD) includes a semiconductor stack structure (1) and an insulating layer (INF) disposed on a side surface of the semiconductor stack structure (1), the semiconductor stack structure (1) including an N-type semiconductor layer (SCL1), a P-type semiconductor layer (SCL2), and an active layer (AL) disposed between the N-type semiconductor layer (SCL1) and the P-type semiconductor layer (SCL2), and
the semiconductor stack structure (1) further includes a fluorinated area (FA) disposed adjacent to the insulating layer (INF),
**characterised in that**
the insulating layer (INF) includes a first insulating layer (INF1) disposed on the side surface of the semiconductor stack structure (1), and a second insulating layer (INF2) disposed on the first insulating layer (INF1),
the first insulating layer (INF1) is disposed between the fluorinated area (FA) and the second insulating layer (INF2),
each of the first insulating layer (INF1) and the second insulating layer (INF2) includes a silicon oxide or a metal oxide,
the first insulating layer (INF1) further includes fluorine (F), and
the second insulating layer (INF2) does not include fluorine (F).

9. The display device according to claim 8, further comprising:
a first electrode (EL1) and a second electrode (EL2) disposed on the base layer (BSL), wherein
the light emitting element (LD) includes a first end (EP1) and a second end (EP2), and
the light emitting element (LD) is electrically connected to the first electrode (EL1) at the first end (EP1) and is electrically connected to the second electrode (EL2) at the second end (EP2).

10. The display device according to claim 8 or claim 9, further comprising:
a first alignment electrode (ALE1) and a second alignment electrode (ALE2) disposed on the base layer (BSL),
wherein the light emitting element (LD) is aligned between the first alignment electrode (ALE1) and the second alignment electrode (ALE2).

11. The display device according to any one of claims 8 to 10, wherein
the fluorinated area (FA) of the semiconductor stack structure (1) comprises a GaFN-based material,
the fluorinated area (FA) has a non-uniform fluorine (F) concentration gradient with respect to depth from an outer surface of the semiconductor stack structure (1), and
the fluorinated area (FA) has a peak concentration of fluorine (F) at a depth in a range of 0.001 µm to 0.01 µm from the outer surface of the semiconductor stack structure (1), and
the peak concentration is in a range from 1.2x10¹⁸ [number/cm³] to 1.6x10¹⁸ [number/cm³].

12. A method of manufacturing a light emitting element (LD), the method comprising:
forming a semiconductor stack layer on a growth substrate (GS);
patterning the semiconductor stack layer;
forming a fluorinated area (FA) on a side surface of a patterned semiconductor stack structure (1); and
forming an insulating layer (INF) on the side surface of the patterned semiconductor stack structure (1),
**characterised in that**
the forming of the insulating layer (INF) includes forming a plurality of insulating layers (INF) after the forming of the fluorinated area (FA), or
the forming of the insulating layer (INF) includes forming a first insulating layer (INF1) on the side surface of the patterned semiconductor stack structure (1), and forming a second insulating layer (INF2) on the first insulating layer (INF1),
the forming of the first insulating layer (INF1) is performed before the forming of the fluorinated area (FA), and
the forming of the second insulating layer (INF2) is performed after the forming of the fluorinated area (FA).

13. The method according to claim 12, wherein the forming of the fluorinated area (FA) includes providing fluorine (F) to the patterned semiconductor stack structure (1) using an ion implantation technique and/or a surface treatment technique.

## Patentansprüche

1. Lichtemittierendes Element (LD), umfassend:
eine Halbleiterstapelstruktur (1), beinhaltend:
eine N-Halbleiterschicht (SCL1);
eine P-Halbleiterschicht (SCL2); und
eine aktive Schicht (AL), die zwischen der N-Halbleiterschicht (SCL1) und der P-Halbleiterschicht (SCL2) angeordnet ist; und
eine Isolierschicht (INF), die an einem seitlichen Abschnitt der Halbleiterstapelstruktur (1) angeordnet ist,
**dadurch gekennzeichnet, dass**
die Halbleiterstapelstruktur (1) ferner einen fluorierten Bereich (FA) beinhaltet, der an die Isolierschicht (INF) angrenzend angeordnet ist,
die Isolierschicht (INF) eine erste Isolierschicht (INF1), die auf dem seitlichen Abschnitt der Halbleiterstapelstruktur (1) angeordnet ist, und eine zweite Isolierschicht (INF2), die auf der ersten Isolierschicht (INF1) angeordnet ist, beinhaltet,
die erste Isolierschicht (INF1) zwischen dem fluorierten Bereich (FA) und der zweiten Isolierschicht (INF2) angeordnet ist,
jede der ersten Isolierschicht (INF1) und der zweiten Isolierschicht (INF2) ein Siliziumoxid oder ein Metalloxid beinhaltet,
die erste Isolierschicht (INF1) ferner Fluor (F) beinhaltet, und
die zweite Isolierschicht (INF2) kein Fluor (F) beinhaltet.

2. Lichtemittierendes Element (LD) nach Anspruch 1, wobei
der fluorierte Bereich (FA) der Halbleiterstapelstruktur (1) besteht ein GaFN-basiertes Material umfasst, und
der fluorierte Bereich (FA) einen ungleichmäßigen Fluor- (F) Konzentrationsgradienten in Bezug auf eine Tiefe von einer Außenfläche der Halbleiterstapelstruktur (1) aufweist.

3. Lichtemittierendes Element (LD) nach Anspruch 2, wobei
der fluorierte Bereich (FA) eine Fluor- (F) Spitzenkonzentration in einer Tiefe in einem Bereich von 0,001 µm bis 0,01 µm von der Außenfläche der Halbleiterstapelstruktur (1) aufweist, und
die Spitzenkonzentration in einem Bereich von 1,2x10¹⁸ [Anzahl/cm³] bis 1,6x10¹⁸ [Anzahl/cm³] liegt.

4. Lichtemittierendes Element (LD) nach einem der Ansprüche 1 bis 3, wobei der fluorierte Bereich (FA) den gesamten seitlichen Abschnitt der Halbleiterstapelstruktur (1) bedeckt.

5. Lichtemittierendes Element (LD) nach einem der Ansprüche 1 bis 3, wobei
der fluorierte Bereich (FA) einen seitlichen Abschnitt der P-Halbleiterschicht (SCL2) und einen seitlichen Abschnitt der aktiven Schicht (AL) bedeckt, und
der fluorierte Bereich (FA) keinen seitlichen Abschnitt der N-Halbleiterschicht (SCL1) bedeckt.

6. Lichtemittierendes Element (LD) nach einem der Ansprüche 2 bis 5, wobei
der fluorierte Bereich (FA) direkt an die Isolierschicht (INF) angrenzt, und
das Metalloxid mindestens ein Metall umfasst, das aus der Gruppe ausgewählt ist, bestehend aus Tantal (Ta), Hafnium (Hf), Zirkonium (Zr), Lanthan (La), Titan (Ti) und Aluminium (Al).

7. Lichtemittierendes Element (LD) nach Anspruch 6, wobei eine Bindungsenergie zwischen Fluor (F) und Gallium (Ga) größer ist als eine Bindungsenergie zwischen Sauerstoff, der im Siliciumoxid oder Metalloxid beinhaltet ist, und Gallium (Ga).

8. Anzeigevorrichtung, umfassend:
eine Basisschicht (BSL); und
ein lichtemittierendes Element (LD), das auf der Basisschicht (BSL) angeordnet ist, wobei
das lichtemittierende Element (LD) eine Halbleiterstapelstruktur (1) und eine Isolierschicht (INF), die auf einer Seitenfläche der Halbleiterstapelstruktur (1) angeordnet ist, beinhaltet, die Halbleiterstapelstruktur (1) eine N-Halbleiterschicht (SCL1), eine P-Halbleiterschicht (SCL2) und eine zwischen der N-Halbleiterschicht (SCL1) und der P-Halbleiterschicht (SCL2) angeordnete aktive Schicht (AL) beinhaltet, und
die Halbleiterstapelstruktur (1) ferner einen fluorierten Bereich (FA) beinhaltet, der an die Isolierschicht (INF) angrenzend angeordnet ist,
**dadurch gekennzeichnet, dass**
die Isolierschicht (INF) eine erste Isolierschicht (INF1), die auf der Seitenfläche der Halbleiterstapelstruktur (1) angeordnet ist, und eine zweite Isolierschicht (INF2), die auf der ersten Isolierschicht (INF1) angeordnet ist, beinhaltet,
die erste Isolierschicht (INF1) zwischen dem fluorierten Bereich (FA) und der zweiten Isolierschicht (INF2) angeordnet ist,
jede der ersten Isolierschicht (INF1) und der zweiten Isolierschicht (INF2) ein Siliziumoxid oder ein Metalloxid beinhaltet,
die erste Isolierschicht (INF1) ferner Fluor (F) beinhaltet, und
die zweite Isolierschicht (INF2) kein Fluor (F) beinhaltet.

9. Anzeigevorrichtung nach Anspruch 8, ferner umfassend:
eine erste Elektrode (EL1) und eine zweite Elektrode (EL2), die auf der Basisschicht (BSL) angeordnet sind, wobei
das lichtemittierende Element (LD) ein erstes Ende (EP1) und ein zweites Ende (EP2) beinhaltet, und
das lichtemittierende Element (LD) am ersten Ende (EP1) elektrisch mit der ersten Elektrode (EL1) verbunden ist und am zweiten Ende (EP2) elektrisch mit der zweiten Elektrode (EL2) verbunden ist.

10. Anzeigevorrichtung nach Anspruch 8 oder Anspruch 9, ferner umfassend:
eine erste Ausrichtungselektrode (ALE1) und eine zweite Ausrichtungselektrode (ALE2), die auf der Basisschicht (BSL) angeordnet sind,
wobei das lichtemittierende Element (LD) zwischen der ersten Ausrichtungselektrode (ALE1) und der zweiten Ausrichtungselektrode (ALE2) ausgerichtet ist.

11. Anzeigevorrichtung nach einem der Ansprüche 8 bis 10, wobei
der fluorierte Bereich (FA) der Halbleiterstapelstruktur (1) besteht ein GaFN-basiertes Material umfasst,
der fluorierte Bereich (FA) einen ungleichmäßigen Fluor- (F) Konzentrationsgradienten in Bezug auf eine Tiefe von einer Außenfläche der Halbleiterstapelstruktur (1) aufweist, und
der fluorierte Bereich (FA) eine Fluor- (F) Spitzenkonzentration in einer Tiefe in einem Bereich von 0,001 µm bis 0,01 µm von der Außenfläche der Halbleiterstapelstruktur (1) aufweist, und
die Spitzenkonzentration in einem Bereich von 1,2x10¹⁸ [Anzahl/cm³] bis 1,6x10¹⁸ [Anzahl/cm³] liegt.

12. Verfahren zum Herstellen eines lichtemittierenden Elements (LD), wobei das Verfahren Folgendes umfasst:
Bilden einer Halbleiterstapelschicht auf einem Wachstumssubstrat (GS);
Strukturieren der Halbleiterstapelschicht;
Bilden eines fluorierten Bereichs (FA) auf einer Seitenfläche einer strukturierten Halbleiterstapelstruktur (1); und
Bilden einer Isolierschicht (INF) auf der Seitenfläche der strukturierten Halbleiterstapelstruktur (1),
**dadurch gekennzeichnet, dass**
das Herstellen der Isolierschicht (INF) ein Bilden mehrerer Isolierschichten (INF) nach dem Bilden des fluorierten Bereichs (FA) beinhaltet, oder
das Bilden der Isolierschicht (INF) ein Bilden einer ersten Isolierschicht (INF1) auf der Seitenfläche der strukturierten Halbleiterschicht (1) und Bilden einer zweiten Isolierschicht (INF2) auf der ersten Isolierschicht (INF1) beinhaltet,
das Bilden der ersten Isolierschicht (INF1) vor dem Bilden des fluorierten Bereichs (FA) durchgeführt wird, und
das Bilden der zweiten Isolierschicht (INF2) nach dem Bilden des fluorierten Bereichs (FA) durchgeführt wird.

13. Verfahren nach Anspruch 12, wobei das Bilden des fluorierten Bereichs (FA) ein Bereitstellen von Fluor (F) an die strukturierte Halbleiterstapelstruktur (1) unter Verwendung einer Ionenimplantationstechnik und/oder einer Oberflächenbehandlungstechnik beinhaltet.

## Revendications

1. Élément électroluminescent (LD) incluant :
une structure de pile semi-conductrice (1), incluant :
une couche semi-conductrice de type N (SCL1) ;
une couche semi-conductrice de type P (SCL2) ; et
une couche active (AL) disposée entre la couche semi-conductrice de type N (SCL1) et la couche semi-conductrice de type P (SCL2) ; et
une couche isolante (INF) disposée sur une partie latérale de la structure de pile semi-conductrice (1),
**caractérisé en ce que**
la structure de pile semi-conductrice (1) inclut en outre une zone fluorée (FA) disposée adjacente à la couche isolante (INF),
la couche isolante (INF) inclut une première couche isolante (INF1) disposée sur la partie latérale de la structure de pile semi-conductrice (1), et une seconde couche isolante (INF2) disposée sur la première couche isolante (INF1),
la première couche isolante (INF1) est disposée entre la zone fluorée (FA) et la seconde couche isolante (INF2),
chacune de la première couche isolante (INF1) et de la seconde couche isolante (INF2) inclut un oxyde de silicium ou un oxyde métallique,
la première couche isolante (INF1) inclut en outre du fluor (F), et
la seconde couche isolante (INF2) n'inclut pas de fluor (F).

2. Élément électroluminescent (LD) selon la revendication 1, dans lequel
la zone fluorée (FA) de la structure de pile semi-conductrice (1) inclut un matériau à base de GaFN, et
la zone fluorée (FA) présente un gradient de concentration de fluor (F) non uniforme en fonction de la profondeur à partir d'une surface extérieure de la structure de pile semi-conductrice (1).

3. Élément électroluminescent (LD) selon la revendication 2, dans lequel
la zone fluorée (FA) présente une concentration maximale de fluor (F) à une profondeur dans une plage de 0,001 µm à 0,01 µm à partir de la surface extérieure de la structure de pile semi-conductrice (1), et
la concentration maximale est dans une plage de 1,2x10¹⁸ [nombre/cm³] à 1,6x10¹⁸ [nombre/cm³].

4. Élément électroluminescent (LD) selon l'une quelconque des revendications 1 à 3, dans lequel la zone fluorée (FA) couvre l'intégralité de la partie latérale de la structure de pile semi-conductrice (1).

5. Élément électroluminescent (LD) selon l'une quelconque des revendications 1 à 3, dans lequel
la zone fluorée (FA) couvre une partie latérale de la couche semi-conductrice de type P (SCL2) et une partie latérale de la couche active (AL), et
la zone fluorée (FA) ne couvre pas une partie latérale de la couche semi-conductrice de type N (SCL1).

6. Élément électroluminescent (LD) selon l'une quelconque des revendications 2 à 5, dans lequel
la zone fluorée (FA) est directement adjacente à la couche isolante (INF), et
l'oxyde métallique comprend au moins un métal choisi parmi un groupe constitué de tantale (Ta), d'hafnium (Hf), de zirconium (Zr), de lanthane (La), de titane (Ti) et d'aluminium (Al).

7. Élément électroluminescent (LD) selon la revendication 6, dans lequel une énergie de liaison entre le fluor (F) et le gallium (Ga) est supérieure à une énergie de liaison entre l'oxygène inclus dans l'oxyde de silicium ou l'oxyde métallique et le gallium (Ga).

8. Dispositif d'affichage, comprenant :
une couche de base (BSL) ; et
un élément électroluminescent (LD) disposé sur la couche de base (BSL), dans lequel
l'élément électroluminescent (LD) inclut une structure de pile semi-conductrice (1) et une couche isolante (INF) disposée sur une surface latérale de la structure de pile semi-conductrice (1), la structure de pile semi-conductrice (1) incluant une couche semi-conductrice de type N (SCL1), une couche semi-conductrice de type P (SCL2) et une couche active (AL) disposée entre la couche semi-conductrice de type N (SCL1) et la couche semi-conductrice de type P (SCL2), et
la structure de pile semi-conductrice (1) inclut en outre une zone fluorée (FA) disposée adjacente à la couche isolante (INF),
**caractérisé en ce que**
la couche isolante (INF) inclut une première couche isolante (INF1) disposée sur la surface latérale de la structure de pile semi-conductrice (1), et une seconde couche isolante (INF2) disposée sur la première couche isolante (INF1),
la première couche isolante (INF1) est disposée entre la zone fluorée (FA) et la seconde couche isolante (INF2),
chacune de la première couche isolante (INF1) et de la seconde couche isolante (INF2) inclut un oxyde de silicium ou un oxyde métallique,
la première couche isolante (INF1) inclut en outre du fluor (F), et
la seconde couche isolante (INF2) n'inclut pas de fluor (F).

9. Dispositif d'affichage selon la revendication 8, comprenant en outre :
une première électrode (EL1) et une seconde électrode (EL2) disposées sur la couche de base (BSL), dans lequel
l'élément électroluminescent (LD) inclut une première extrémité (EP1) et une seconde extrémité (EP2), et
l'élément électroluminescent (LD) est connecté électriquement à la première électrode (EL1) à la première extrémité (EP1) et est connecté électriquement à la seconde électrode (EL2) à la seconde extrémité (EP2).

10. Dispositif d'affichage selon la revendication 8 ou la revendication 9, comprenant en outre :
une première électrode d'alignement (ALE1) et une seconde électrode d'alignement (ALE2) disposées sur la couche de base (BSL),
dans lequel l'élément électroluminescent (LD) est aligné entre la première électrode d'alignement (ALE1) et la seconde électrode d'alignement (ALE2).

11. Dispositif d'affichage selon l'une quelconque des revendications 8 à 10, dans lequel
la zone fluorée (FA) de la structure de pile semi-conductrice (1) comprend un matériau à base de GaFN,
la zone fluorée (FA) présente un gradient de concentration de fluor (F) non uniforme en fonction de la profondeur à partir d'une surface externe de la structure de pile semi-conductrice (1), et
la zone fluorée (FA) présente une concentration maximale de fluor (F) à une profondeur dans une plage de 0,001 µm à 0,01 µm à partir de la surface extérieure de la structure de pile semi-conductrice (1), et
la concentration maximale est dans une plage de 1,2x10¹⁸ [nombre/cm³] à 1,6x10¹⁸ [nombre/cm³].

12. Procédé de fabrication d'un élément électroluminescent (LD), le procédé comprenant :
la formation d'une couche de pile semi-conductrice sur un substrat de croissance (GS) ;
la structuration de la couche de pile semi-conductrice ;
la formation d'une zone fluorée (FA) sur une surface latérale d'une structure de pile semi-conductrice structurée (1) ; et
la formation d'une couche isolante (INF) sur la surface latérale de la structure de pile semi-conductrice structurée (1),
**caractérisé en ce que**
la formation de la couche isolante (INF) inclut la formation d'une pluralité de couches isolantes (INF) après la formation de la zone fluorée (FA), ou
la formation de la couche isolante (INF) inclut la formation d'une première couche isolante (INF1) sur la surface latérale de la structure de pile semi-conductrice structurée (1), et la formation d'une seconde couche isolante (INF2) sur la première couche isolante (INF1),
la formation de la première couche isolante (INF1) est réalisée avant la formation de la zone fluorée (FA), et
la formation de la seconde couche isolante (INF2) est réalisée après la formation de la zone fluorée (FA).

13. Procédé selon la revendication 12, dans lequel la formation de la zone fluorée (FA) inclut l'apport de fluor (F) à la structure de pile semi-conductrice structurée (1) par une technique d'implantation ionique et/ou une technique de traitement de surface.
